(19) Europäisches Patentamt
European Patent Office
Office européen des brevets

(11) Publication number: **0 459 608 A2**

# (12) EUROPEAN PATENT APPLICATION

(21) Application number: **91301543.4**

(22) Date of filing: **26.02.91**

(51) Int. Cl.[5]: **C08L 63/10**, C08L 67/06, C08L 67/07, C08L 75/16, //C09D163/10

(30) Priority: **31.05.90 JP 143081/90**

(43) Date of publication of application: **04.12.91 Bulletin 91/49**

(84) Designated Contracting States: **DE FR GB NL**

(71) Applicant: **SOMAR CORPORATION**
**11-2, Ginza 4-chome Chuo-ku**
**Tokyo 104(JP)**

(72) Inventor: **Yamazaki, Mari**
**Sasai-Mansion 204, 3-17-9 Osawa**
**Koshigaya-shi, Saitama-ken(JP)**
Inventor: **Kawano, Takayuki**
**250-43 Fujitsuka**
**Kasukabe-shi, Saitama-ken(JP)**
Inventor: **Nagase, Rihei**
**Dai-2 Swan Heights 203, 3-31-5 Sekihara**
**Adachi-ku, Tokyo(JP)**

(74) Representative: **Allam, Peter Clerk et al**
**LLOYD WISE, TREGEAR & CO. Norman House 105-109 Strand**
**London WC2R 0AE(GB)**

## (54) Photo-curable composition.

(57) A photo-curable composition is disclosed which includes a 5-60 % by weight of a polymerizable prepolymer, 5-70 % by weight of a product obtained by reaction of a 1 mole portion of (meth)acrylic acid with a more than 1 mole portion of a diglycidyl ether of a bisphenol, 10-90 % by weight of a reactive diluent, and 0.2-20 % by weight of a polymerization initiator, the amounts being based on the total amount of the prepolymer, product and diluent.

EP 0 459 608 A2

This invention relates generally to a photo-curable composition and, more specifically, to a photo-curable resin composition useful as an adhesive for bonding electric chip parts to printed wiring boards, as a coating agent providing an electrically insulating coatings and as a sealing agent.

In mounting chip parts such as resistors and capacitors on a printed wiring board, it is a general practice to first bond such parts on the board with a suitable adhesive, the bonded parts being subsequently soldered to provide firm connection between the contacts of the parts and the wiring of the board. Since the adhesive is subjected to high temperatures and abrupt thermal shock in the soldering stage, it is highly desirous to provide an adhesive which withstands high temperatures. Additionally, photo-curable compositions for use in coating and sealing purposes are desired to have a resistance to moisture and exhibit good electrical insulation even when exposed to moistened conditions. Known photo-curable compositions, however, are not fully satisfactory with respect to the above properties.

The present invention has been made to provide a photo-curable composition hardenable upon being irradiated with an actinic light to provide a coating or an adhesive exhibiting strong adhesion and excellent electrical insulation which properties are not deteriorated even when subjected to high temperatures or highly humid conditions for a long period of time.

In accordance with the present invention there is provided a photo-curable composition comprising an ingredient (a) consisting of a polymerizable prepolymer, an ingredient (b) consisting of a product obtained by reaction of (meth)acrylic acid with a diglycidyl ether of a bisphenol with a molar ratio of the diglycidyl ether to the (meth)acrylic acid being greater than 1:1, an ingredient (c) consisting of a reactive diluent and an ingredient (d) consisting of a polymerization initiator, wherein the amounts of the ingredients (a)-(d) based on the total amount of the ingredients (a)-(c) are as follows:

ingredient (a): 5-60 % by weight
ingredient (b): 5-70 % by weight
ingredient (c): 10-90 % by weight
ingredient (d): 0.2-20 % by weight.

The present invention will now be described in detail below.

In the present specification and the appended claims, the term "(meth)acrylate" is a generic term for acrylates and methacrylates, the term "(meth)acrylic acid" for acrylic acid and methacrylic acid and the term "(meth)acryloyl" for acryloyl and methacryloyl.

The ingredient (a), namely a polymerizable prepolymer to be used in the photo-curable composition is a prepolymer which is polymerizable upon being irradiated with an actinic light such as UV light and may be, for example, an ethylenically unsaturated polyester resin, an epoxy(meth)acrylate, urethan(meth)acrylate and an oligoester (meth)acrylate.

The polyester resin preferably has a molecular weight of 1,000 to 10,000 and may be obtained by reaction of an ethylenically unsaturated polybasic carboxylic acid, such as maleic anhydride, fumaric acid, itaconic acid, tetrahydroxyphthalic anhydride or methyltetrahydrophthalic anhydride with a glycol such as ethylene glycol, propylene glycol, diethylene glycol, neopentyl glycol or bisphenol A propionic acid adduct. Such polyester resins are commercially available, for example, as UPICA 8554 (manufactured by Nippon Upica Inc.) and NEWTRACK 410S (manufactured by Kao Inc.).

The epoxy(meth)acrylate is a product obtained by full esterification of an epoxy resin with (meth)acrylic acid and preferably has a molecular weight of 350-3,000, more preferably 480-2,000. The epoxy resin is preferably a glycidyl ether epoxy resin such as a bisphenol A epoxy resin, a bisphenol F epoxy resin, a brominated bisphenol A epoxy resin, a phenol novolak epoxy resin or a cresol novolak epoxy resin. Examples of commercially available epoxy(meth)acrylates include RIPOXY VR-60 and RIPOXY VR-90 (both manufactured by Showa Kobunshi Inc.).

The urethane (meth)acrylate is a product obtained by reacting a hydroxyalkyl(meth)acrylate with a terminal isocyanate group-containing urethane compound which is obtainable by reacting an aliphatic diol (e.g. ethylene glycol) or an ether diol having two hydroxyl groups at both terminal ends (e.g. poly(ethylene glycol)) with a stoichiometrically excess amount of a diisocyanate such as toluenediisocyanate or isophoronediisocyanate. Such urethane (meth)acrylates are commercially available as, for example, UAS-10 (manufactured by Negami Kogyo Inc.), UVITHANE 893 (manufactured by Thiocole Inc.) and U-6HA (manufactured by Shin-Nakamura Kagaku K. K.).

The oligoester (meth)acrylate is a polyfunctional (meth)acrylate having an ester skeleton obtained from an aromatic carboxylic acid and is commercially available as ARONIX M-8060 and ARONIX M-7100 (both manufactured by Toa Gosei Kagaku Kogyo K. K.). An example of such oligoester is an isophthalic acid ester derivative of the formula:

$CH_2=CH\text{-}CO\text{-}(OCH_2CH_2)_3\text{-}O\text{-}CO\text{-}(CH_2)_4\text{-}CO\text{-}O\text{-}CH_2CH_2\text{-}O\text{-}CO\text{-}C_6H_4\text{-}CO\text{-}O\text{-}CH_2CH_2CH(CH_3)\text{-}O\text{-}CO\text{-}$

CH = $CH_2$

The ingredient (b) is a reaction product obtained by reacting 1 mol of (meth)acrylic acid with more than 1 mol, preferably 1.2-5 mols, of a diglycidyl ether of a bisphenol. Examples of the bisphenols include bisphenol A, bisphenol F, bisphenol AD and bisphenol S. The reaction is suitably carried out in the presence of an esterification catalyst such as benzyldimethylamine at a temperature and for a period of time sufficient for substantially all the (meth)acrylic acid to be consumed by esterification with the epoxy groups. The reaction product contains unreacted diglycidyl ether of a bisphenol and a resin bearing both (meth)acryloyl and epoxy groups. Such a resin may be, for example, a compound having the formula:

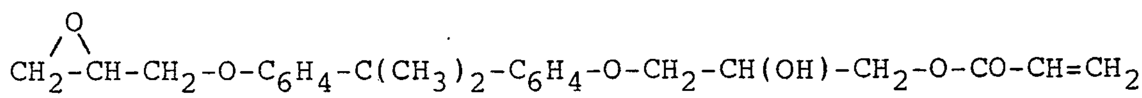

when bisphenol A is used as the bisphenol.

The ingredient (c) which is a reactive diluent serves to adjust the viscosity of the photo-curable composition to a suitable range and to change the properties of cured adhesive layers obtained therefrom. The reactive diluent is suitably a mono or polyfunctional (meth)acrylate containing no epoxy groups. Examples of such polyfunctional (meth)acrylates include trimethylolpropane tri(meth)acrylate, pentaerythritol tetra(meth)acrylate, dipentaerythritol hexa(meth)acrylate, 1,6-hexanediol di(meth)acrylate, triethylene glycol di(meth)acrylate, neopentyl glycol di(meth)acrylate, polyethylene glycol di(meth)acrylate, hydroxypivalic acid neopentylglycol di(meth)acrylate, a (meth)acrylate of ethylene oxide-containing bisphenol A and a dibasic aliphatic acid diglycidyl ester di(meth)acrylate. The polyfunctional (meth)acrylates are commercially available as VISCOAT #3700, VISCOAT #700 (both manufactured by Osaka Yuki K. K.), MANDA (manufactured by Nippon Kayaku K. K.), ARONIX M6100, ARONIX M6300 (both manufactured by Toa Gosei Kagaku Kogyo K. K), MONOSIZER TD-1600A (manufactured by Dainihon Ink K. K.) And ULB-20GEA (manufactured by Okamura Seiyu K. K.). Illustrative of suitable monofunctional (meth)acrylates are hydroxyethyl (meth)acrylate, tetrahydrofurfuryl (meth)acrylate, phenoxyethyl (meth)acrylate, 2-hydroxy-3-phenoxypropyl (meth)acrylate, dicyclopentenyloxyethyl (meth)acrylate and dicyclopentenyl (meth)acrylate.

In the photo-curable composition according to the present invention, the amounts of ingredients (a)-(c) are as follows:

| | Amount (% by weight*) | |
|---|---|---|
| | Critical | Preferred |
| Ingredient (a) | 5-60 | 10-50 |
| Ingredient (b) | 5-70 | 10-60 |
| Ingredient (c) | 10-90 | 20-80 |

* based on the total weight of Ingredients (a)-(c)

An amount of the ingredient (a) below 5 % by weight is disadvantageous because the hardened resin is soft and the adhesion strength is poor. When the amount of the ingredient (a) exceeds 60 % by weight, the resulting composition becomes viscous and causes a difficulty in coating operations. When the amount of the ingredient (b) is below 5 % by weight, the hardened resin fails to exhibit desired resistance to moisture. Too large an amount of the ingredient (b), on the other hand, causes reduction in ahdesion strength of the hardened resin. An amount of the ingredient (c) below 10 % by weight is insufficient to provide a desired dilution effect so that coating operations cannot be smoothly performed. When the amount of the ingredient (c) exceeds 90 % by weight, the viscosity of the composition is so low that it becomes difficult to smoothly perform the coating and, also, the hardened resin becomes poor in electrical insulation.

The ingredient (d), namely a polymerization initiator, to be used in the present invention includes a photopolymerization initiator, such as a benzoin ether compound, a benzophenone compound, an acetophenone compound or a thioxanthone compound. The photopolymerization initiator may be used in conjunction with a thermal polymerization initiator, such as a peroxide compound.

Illustrative of suitable photopolymerization initiators are benzoin isopropyl ether, benzoin isobutyl ether, benzophenone, 2,2-dimethoxy-2-phenylacetophenone, 1-hydroxycyclohexyl phenyl ketone, p-isopropyl-α-hydroxyisobutylphenone, α-hydroxyisobutylphenone, 1,1-dichloroacetophenone, 2-chlorothioxanthone, 2-methylthioxanthone and methylbenzoyl formate. These initiators may be used by themselves or as a mixture of two or more.

Examples of suitable thermal polymerization initiators include ketone peroxides such as methyl ethyl ketone peroxide and cyclohexanone peroxide; diacyl peroxides such as acetyl peroxide and benzoyl peroxide; hydroperoxides such as t-butyl hydroperoxide and cumene hydroperoxide; dialkylperoxides such as di-t-butyl peroxide and dicumyl peroxide; alkyl peresters such as t-butyl peracetate, t-butyl perbenzoate; peroxycarbonates such as diisopropyl peroxydicarbonate and bis(4-t-butylcyclohexyl)peroxydicarbonate; and peroxy ketals such as 1,1-bis(t-butylperoxy)-3,3,5-trimethylcyclohexaneand 1,1-bis(t-butylperoxy)-cyclohexane. These initiators may be used by themselves or as a mixture of two or more.

The ingredient (d) is generally used in an amount of 0.2-20 % by weight, preferably 0.5-15 % by weight based on the total amount of the ingredients (a)-(c). An amount of the ingredient (d) below 0.2 % by weight is insufficient to fully harden the composition and is disadvantageous because the hardened resin becomes poor in resistance to moisture. When the amount of the ingredient (d) is above 20 % by weight, the degree of polymerization is reduced so that the hardened resin becomes soft and poor in moisture resistance.

The photo-curable composition according to the present invention may additionally contain one or more customarily used additives such as a chelate agent, a thermal polymerization inhibitor, a colorant, a thixotropic agent, a curing accelerator and an inorganic filler. Examples of the chelate agents include iminodiacetic acid, N-methyliminodiacetic acid, nitrilotriacetic acid, ethylenediamine-N,N'-diacetic acid, ethylenediamine-N,N,N',N'-tetraacetic acid, N-2-hydroxyethylethylenediamine-N,N',N'-triacetic acid, sodium salts of the above acids, and N,N,N',N'-tetrakis-(2-hydroxypropyl)ethylenediamine. Examples of the thermal polymerization inhibitors include hydroquinone, p-methoxyphenol, benzoquinone, phenothiazine and cupferron. Examples of the colorants include azo dyes, phthalocyanine dyes, isoindolinone dyes, anthraquinone dyes and carbon black. Examples of the thixotropic agents include bentonite and finely divided anhydrous silica. Examples of the curing accelerator include metal salts of long chain organic acids such as cobalt naphthenate and cobalt octenate; amines such as dimethylaniline, N-phenylmorphorine; quarternary ammonium slats such as triethylbenzylammonium chloride; and aminophenols such as 2,4,6-tris(dimethylaminomethyl)phenol. Examples of the inorganic filler include silica, talc, alumina and barium sulfate.

The photo-curable resin composition according to the present invention may be suitably used as an adhesive applied to one of the two articles to be bonded with each other. The application of the composition on a bonding surface may be effected by using a dispenser, a screen printer, a roll coater or any other suitable means. The bonding surface may be a metal, a glass, a plastic or a ceramic surface. The composition is particularly utilized for fixation of plastic or metal casings, for bonding glass articles, for mounting electric or electronic parts on printed wiring boards and for forming solder resist patterns on printed wiring boards.

The hardening of the resin composition may be effected by irradiation of actinic light, generally UV light having a wavelength in the range of 240-450 nm with which the photopolymerization initiator is activated. The source of the UV light may be, for example, a chemical lamp, a middle or high pressure mercury lamp, a xenon lamp or a metal halide lamp. When the resin composition additionally contains a thermal polymerization initiator, the irradiation of actinic light may be suitably followed by a heat treatment at 40-250 °C, preferably 80-180 °C, in a hot air furnace or an infra-red or far infra-red furnace to complete the hardening of the resin composition.

The following examples will further illustrate the present invention. In the examples, "part" is by weight.

Synthesis Example 1

Synthesis of Ingredient (b):

Into 1 liter separable flask equipped with a stirrer, a gas feed conduit-bearing thermometer, a reflux condenser and a dropping funnel, 360 g (1 mol) of an epoxy resin (Epikote 828 manufactured by Mitsubishi Yuka Shell Inc.), 36 g (0.5 mol) of acrylic acid, 1.2 g of benzylmethylamine and 0.08 g of p-benzoquinone (polymerization inhibitor) were placed. The contents in the flask were reacted at 120-130 °C in the nitrogen stream for 3 hours to obtain a product in the form of a light red-brown syrup having an acid value of almost zero. The product contained unreacted epoxy resin and partially esterified epoxy resin.

Examples 1-3 and Comparative Examples 1-2

Adhesive compositions were prepared by mixing the following ingredients for 2 hours with a planetary mixer.

(a) Epoxyacrylate (VR-60 manufactured by Showa Kobunshi Inc.) in an amount shown in Table 1 below

(b) Ingredient (b) obtained in above Synthesis Example 1 in an amount shown in Table 1 below

(c) 1:1 mixture of phenoxyethyl acrylate and 1,6-hexanediol dimethacrylate: 15 parts

(d) Photopolymerization initiator, 2-Hydroxy-2-methyl-1-phenylpropane-1-one (DAROCURE 1173 manufactured by Merck Inc.) 3 parts

(e) Thermopolymerization initiator, 1,1-Bis (t-butylperoxy)-3,3,5-trimethylcyclohexane (PERHEXA 3M manufactured by Nippon Yushi Inc.) 3 parts

(f) Polymerization inhibitor, N-Nitrosophenylhydroxylamine ammonium salt (CUFERRON manufactured by Wako Junyaku Inc.) 0.05 part

(g) Inorganic filler, Talc (HYTRON A manufactured by Takehara Kagaku Inc.) 30 parts

The thus obtained compositions were then tested for their moisture resistance and adhesion strength and the results are summarized in Table 1. The test methods are as follows:

Initial Insulation Resistance:

In accordance with Insulation Resistance Test as specified in JIS Z3197 (1986), a sample adhesive is applied on a specified comb-like electrode (JIS II-type glass epoxy electrode with a thickness of 1.6 mm) to a thickness of 100 μm by screen printing. The coating is irradiated with UV rays using a 80 W/cm high pressure mercury lamp at a distance of 20 cm for about 20 seconds. The resulting coating is immediately heated at 120 °C for 10 minutes in a hot chamber and then allowed to be cooled to room temperature. The cured coating is measured for its insulation resistance at an impressed voltage of 500 V.

Insulation Resistance after Exposure to Moisture:

In the same manner as in the above test, a comb-like electrode is coated with a sample adhesive and cured. The coated electrode is placed in a constant temperature/humidity chamber and maintained at a temperature of 40 °C and a relative humidity of above 95 % for 96 hours. The resulting coat is measured for its insulation resistance in the same manner as above.

Moisture resistance is evaluated from the above results and is rated as follows:

A: Very good : $10^{12}$ ohms or more
B: Good: $10^{11}$ ohms or more but less than $10^{12}$ ohms
C: No good: $10^{10}$ ohms or more but less than $10^{11}$ ohms
D: Poor: $10^{10}$ ohms

Adhesion Strength:

A sample adhesive (about 0.4 mg) is applied to a printed wiring board and a chip part (3.2 mm x 1.6 mm ceramic capacitor) is placed on the center of the adhesive layer. This is then irradiated with UV rays using a 80 W/cm high pressure mercury lamp at a distance of 20 cm for about 20 seconds and, thereafter, immediately heated at 120 °C for 10 minutes. The shear adhesion strength between the board and the chip part is then measured.

Table 1

| Example No. | 1 | 2 | 3 | Comp. 1 | Comp. 2 |
|---|---|---|---|---|---|
| Ingredients | | | | | |
| VR-60 | 20 | 35 | 50 | 65 | 5 |
| Ingredient (b) | 50 | 35 | 20 | 5 | 65 |
| Characteristics | | | | | |
| Initial resistance (Ω) | $1.0 \times 10^{14}$ | $1.0 \times 10^{14}$ | $1.0 \times 10^{14}$ | $1.5 \times 10^{13}$ | $1.7 \times 10^{14}$ |
| Resistance after moisture resistance test (Ω) | $5.0 \times 10^{12}$ | $3.0 \times 10^{12}$ | $1.0 \times 10^{12}$ | $2.0 \times 10^{10}$ | $5.0 \times 10^{12}$ |
| Moisture resistance | A | A | A | C | A |
| Adhesion strength (kg) | 4.0 | 4.5 | 5.0 | 4.5 | 1.0 |

Examples 4-6 and Comparative Examples 3-4

Adhesive compositions were prepared by mixing the following ingredients for 2 hours with a planetary mixer.

(a) Unsaturated polyester resin (molecular weight: about 2000, UPICA 8524 manufactured by Nihon Upica K. K.) in an amount shown in Table 2 below

(b) Ingredient (b) obtained in above Synthesis Example 1 in an amount shown in Table 2 below

(c) 3:2 mixture of phenoxyethyl acrylate and 1,6-hexanediol dimethacrylate: 50 parts

(d) Photopolymerization initiator, 2-Hydroxy-2-methyl-1-phenylpropane-1-one (DAROCURE 1173 manufactured by Merck Inc.) 3 parts

(e) Thermopolymerization initiator, 1,1-Bis (t-butylperoxy)-3,3,5-trimethylcyclohexane (PERHEXA 3M manufactured by Nippon Yushi Inc.) 3 parts

(f) Polymerization inhibitor, N-Nitrosophenylhydroxylamine ammonium salt (CUFERRON manufactured by Wako Junyaku Inc.) 0.05 part

(g) Inorganic filler, Talc (HYTRON A manufactured by Takehara Kagaku Inc.) 30 parts

These adhesives were tested for 'their moisture resistance and adhesion strength tests in the same manner as described above. The results are summarized in Table 2.

Table 2

| Example No. | 4 | 5 | 6 | Comp. 3 | Comp. 4 |
|---|---|---|---|---|---|
| Ingredients | | | | | |
| UPICA 8524 | 10 | 25 | 40 | 50 | - |
| Ingredient (b) | 40 | 25 | 10 | - | 50 |
| Characteristics | | | | | |
| Initial resistance (Ω) | $1.5 \times 10^{13}$ | $1.5 \times 10^{13}$ | $1.5 \times 10^{13}$ | $1.0 \times 10^{13}$ | $1.5 \times 10^{13}$ |
| Resistance after moisture resistance test (Ω) | $1.0 \times 10^{12}$ | $7.0 \times 10^{11}$ | $1.0 \times 10^{11}$ | $5.0 \times 10^{9}$ | $1.0 \times 10^{12}$ |
| Moisture resistance | A | B | B | D | A |
| Adhesion strength (kg) | 3.5 | 4.0 | 4.0 | 4.0 | 1.0 |

Example 7 and comparative Example 5

Adhesive compositions were prepared by mixing the following ingredients for 2 hours with a planetary mixer.

(a) Urethaneacrylate (UAS-10 manufactured by Negami Kogyo Inc., molecular weight: about 1500) in an amount shown in Table 3 below

(b) Ingredient (b) obtained in above Synthesis Example 1 in an amount shown in Table 3 below

(c) 1:1 mixture of tetrahydrofurfuryl methacrylate and 1,6-hexanediol dimethacrylate: 70 parts

(d) Photopolymerization initiator, 2-Hydroxy-2-methyl-1-phenylpropane-1-one (DAROCURE 1173 manufactured by Merck Inc.) 3 parts

(e) Thermopolymerization initiator, 1,1-Bis (t-butylperoxy)-3,3,5-trimethylcyclohexane (PERHEXA 3M manufactured by Nippon Yushi Inc.) 3 parts

(f) Polymerization inhibitor, N-Nitrosophenylhydroxylamine ammonium salt (CUFERRON manufactured by Wako Junyaku Inc.) 0.05 part

(g) Inorganic filler, Talc (HYTRON A manufactured by Takehara Kagaku Inc.) 30 parts

These adhesives were tested for their moisture resistance and adhesion strength tests in the same manner as described above. The results are summarized in Table 3.

Table 3

| Example No. | 7 | Comp. 3 |
|---|---|---|
| Ingredients | | |
| UAS-10 | 15 | 30 |
| Ingredient (b) | 15 | - |
| Characteristics | | |
| Initial resistance (Ω) | $5.0x10^{13}$ | $1.5x10^{13}$ |
| Resistance after moisture resistance test (Ω) | $3.0x10^{11}$ | $7.5x10^{18}$ |
| Moisture resistance | B | D |
| Adhesion strength (kg) | 3.5 | 4.0 |

Examples 8-10 and Comparative Examples 6-7

Coating compositions were prepared by mixing the following ingredients with a dissolver and then with a roll mixer.

(a) Epoxyacrylate (VR-60) in an amount shown in Table 4 below

(b) Ingredient (b) obtained in above Synthesis Example 1 in an amount shown in Table 4 below

(c) 1:1 mixture of phenoxyethyl acrylate and 1,6-hexanediol dimethacrylate: 30 parts

(d) Photopolymerization initiator, 2-Hydroxy-2-methyl-1-phenylpropane-1-one (DAROCURE 1173 manufactured by Merck Inc.) 3 parts

(e) Thermopolymerization initiator, 1,1-Bis (t-butylperoxy)-3,3,5-trimethylcyclohexane (PERHEXA 3M manufactured by Nippon Yushi Inc.) 3 parts

(f) Polymerization inhibitor, N-Nitrosophenylhydroxylamine ammonium salt (CUFERRON manufactured by Wako Junyaku Inc.) 0.05 part

(g) Inorganic filler, Talc (HYTRON A manufactured by Takehara Kagaku Inc.) 7 parts Barium sulfate 20 parts

(h) Phthalocyanine Green 0.8 part

These solder resist compositions were tested for their moisture resistance, adhesion and heat resistance tests in the manner as described below. The results are summarized in Table 4.

Initial Insulation Resistance:

In accordance with Insulation Resistance Test as specified in JIS Z3197 (1986), a sample composition is applied on a specified comb-like electrode (JIS II-type glass epoxy electrode with a thickness of 1.6 mm) to a thickness of about 20 μm by screen printing. The coating is irradiated with UV rays by passage beneath three 80 W/cm high pressure mercury lamps at a distance of 10 cm at a conveying speed of 2 m/minute. The resulting cured coating is measured for its insulation resistance at room temperature with an impressed voltage of 500 V.

Insulation Resistance after Exposure to Moisture:

In the same manner as in the above test, a comb-like electrode is coated with a sample composition and cured. The coated electrode is placed in a constant temperature/humidity chamber and maintained at a temperature of 40 °C and a relative humidity of above 95 % for 200 hours. The resulting coat is measured for its insulation resistance in the same manner as above.

Moisture resistance is evaluated from the above results and is rated as follows:

A: Very good : $10^{12}$ ohms or more
B: Good: $10^{11}$ ohms or more but less than $10^{12}$ ohms
C: No good: $10^{10}$ ohms or more but less than $10^{11}$ ohms
D: Poor: $10^{10}$ ohms

Adhesion:

Test is conducted in accordance with JIS D0202 8.12. A sample coating composition is applied on a copper clad glass epoxy board to a thickness of about 20-30 µm by screen printing. The coating is irradiated with UV rays by passage beneath three 80 W/cm high pressure mercury lamps at a distance of 10 cm at a conveying speed of 2 m/minute. The resulting cured coating on the board is cut to form 10x10 checkers. A cellophane adhesive tape is applied onto the cut coating and is peeled. The number of the checkers transferred from the board to the cellophane adhesive tape is counted to evaluate the adhesive strength of the coating. The evaluation is rated as follows:
A: 0
B: 1-20
C: over 20

Adhesion after Immersion in Solder Bath:

In the same manner as in the above test, a coating is formed on a glass epoxy electrode. In accordance with the method specified in JIS D0202 8.15, the coated board is immersed in a solder bath at 260 °C for 10 seconds and is then cooled to room temperature. Thereafter, the appearance of the coating is observed. The heat resistance is evaluated based on the following ratings.
o: No abnormity
x: Swelling, melting or exfoliation is observed

Table 4

| Example No. | 8 | 9 | 10 | Comp. 6 | Comp. 7 |
|---|---|---|---|---|---|
| Ingredients | | | | | |
| VR-60 | 20 | 35 | 50 | 65 | 5 |
| Ingredient (b) | 50 | 35 | 20 | 5 | 65 |
| Characteristics | | | | | |
| Initial resistance (Ω) | $1.0 \times 10^{14}$ | $1.0 \times 10^{14}$ | $1.0 \times 10^{14}$ | $1.5 \times 10^{13}$ | $1.7 \times 10^{14}$ |
| Resistance after moisture resistance test (Ω) | $5.0 \times 10^{12}$ | $3.0 \times 10^{12}$ | $1.0 \times 10^{12}$ | $2.0 \times 10^{10}$ | $5.0 \times 10^{12}$ |
| Moisture resistance | A | A | A | C | A |
| Adhesion strength | A | A | A | B | C |
| Heat resistance | o | o | o | x | x |

## Claims

1. A photo-curable composition comprising ingredient (a) consisting of a polymerizable prepolymer, ingredient (b) consisting of a product obtained by reaction of (meth)acrylic acid with a diglycidyl ether of a bisphenol with a molar ratio of the diglycidyl ether to the (meth)acrylic acid being greater than 1:1, ingredient (c) consisting of a reactive diluent and ingredient (d) consisting of a polymerization initiator, wherein the amounts of ingredients (a)-(d) based on the total amount of ingredients (a)-(c) are as follows:

    ingredient (a): 5-60 % by weight
    ingredient (b): 5-70 % by weight
    ingredient (c): 10-90 % by weight
    ingredient (d): 0.2-20 % by weight.

2. A composition as claimed in claim 1, wherein said polymerizable prepolymer is at least one member selected from the group consisting of unsaturated polyesters, epoxy(meth)acrylates, urethane (meth)-acrylates and oligoester (meth)acrylates.

3. A composition as claimed in claim 1, wherein said product of ingredient (b) is obtained by using 1.2-5 moles of the diglycidyl ether per mole of the (meth)acrylic acid.

4. A composition as claimed in claim 1, wherein said reactive diluent is a member selected from the group consisting of trimethylolpropane tri(meth)acrylate, pentaerythritol tetra(meth)acrylate, dipentaerythritol hexa(meth)acrylate, 1,6-hexanediol di(meth)acrylate, triethylene glycol di(meth)acrylate, neopentyl glycol di(meth)acrylate, polyethylene glycol di(meth)acrylate, hydroxypivalic acid neopentylglycol di(meth)acrylate, dibasic resin acid diglycidyl ester di(meth)acrylates, hydroxyethyl (meth)-acrylate, tetrahydrofurfuryl (meth)acrylate, phenoxyethyl (meth)acrylate, and dicyclopentnyl (meth)-acrylate.